**Europäisches Patentamt**

**European Patent Office**

**Office européen des brevets**

(19)

(11) Veröffentlichungsnummer: **0 011 711**
**B1**

(12) **EUROPÄISCHE PATENTSCHRIFT**

(45) Veröffentlichungstag der Patentschrift: **13.07.83**

(21) Anmeldenummer: **79104130.4**

(22) Anmeldetag: **24.10.79**

(51) Int. Cl.³: **G 01 R 13/40,**
**G 01 R 19/14,**
**G 01 R 19/155**

(54) Prüfeinrichtung zum stufenweisen Anzeigen einer Messspannung.

(30) Priorität: **26.10.78 DE 2846675**

(43) Veröffentlichungstag der Anmeldung:
**11.06.80 Patentblatt 80/12**

(45) Bekanntmachung des Hinweises auf die Patenterteilung:
**13.07.83 Patentblatt 83/28**

(84) Benannte Vertragsstaaten:
**AT BE CH FR GB IT LU NL SE**

(56) Entgegenhaltungen:
**DE - A - 2 233 765**
**DE - A - 2 503 440**
**DE - A - 2 503 855**
**DE - B - 2 717 826**
**DE - C - 2 060 884**
**US - A - 3 555 420**
**US - A - 3 818 495**
**US - A - 4 027 236**

**ELEKTOR, Band 4, Nr. 7, 8, Juli/August 1978,**
**Beek, NL, "Car ammeter", Seite 79**

(73) Patentinhaber: **SIEMENS AKTIENGESELLSCHAFT**
**Berlin und München Wittelsbacherplatz 2**
**D-8000 München 2 (DE)**

(72) Erfinder: **Koslar, Manfred, Dipl.-Ing.**
**Ludwig-Uhland-Strasse 3**
**D-4840 Rheda-Wiedenbrück (DE)**

(56) Entgegenhaltungen:
**ELECTRONIC DESIGN NEWS, Band 22, Nr. 20,**
**November 1977, R. A. SNYDER: "Simple**
**polarity indicator suits DMM's or DPM's", Seite**
**110**

Prüfeinrichtung zum stufenweisen Anzeigen einer Meßspannung

Die Erfindung betrifft eine Prüfeinrichtung zum Anzeigen einer elektrischen Meßspannung und ggf. deren Polarität, die zwei mit Kontaktspitzen versehene Griffe umfaßt, die durch ein Kabel verbunden sind und von denen einer ein Anzeigeeinheit aufnimmt, die eine Anzahl bzw. eine Reihenschaltung von nichtlinearen Leuchtelementen sowie einen Spannungsteiler aus mehreren in Reihe geschalteten Widerständen enthält, der von der Meßspannung beaufschlagt ist.

In der DE—PS 20 60 884 ist eine Prüfeinrichtung zum Anzeigen der Polarität bzw. der Phasenlage von elektrischen Potentialen gegenüber einem vorgegebenen Bezugspotential beschrieben, bei der zwei antiparallel geschaltete Leuchtdioden mit vorgeschaltetem Strombegrenzungswiderstand verwendet werden. Die beiden Leuchtdioden sind in mindestens einer Öffnung eines griffelförmigen Gehäuses geschützt angeordnet, das gleichzeitig den Strombegrenzungswiderstand enthält und an einer Stirnseite eine Metallspitze trägt. Die Wände des griffelförmigen Gehäuses haben einen Druckbruch, durch den die Leuchtaustritte von zwei Dioden von außen zu sehen sind. Die beiden leuchtdioden sind antiparallel geschaltet und einerseits über den Strombegrenzungswiderstand mit der Metallspitze sowie andererseits mit einer aus dem griffelförmigen Gehäuse herausgeführten Prüfleitung verbunden. Bei der Prüfung einer Gleichspannung leuchtet je nach Polarität die eine oder die andere Leuchtdiode auf, während bei Prüfung einer Wechselspannung beide Leuchtdioden aufleuchten.

Wird als Strombegrenzungswiderstand ein keramischer Kaltleiter verwendet, der — wie bekannt — aus ferroelektrischem Material auf der Basis von n- und/oder p-dotiertem Bariumtitanat besteht und im Bereich der Curietemperatur eine sprunghafte Zunahme seines elektrischen Widerstandes um etwa 3 oder mehr Zehnerpotenzen aufweist, so können Spannungen von etwa 2 V und bis zum 500 V mit dieser Einrichtung geprüft werden. Der keramische Kaltleiter übt dabei eine Schutzfunktion für die Leuchtdioden aus, indem er durch Eigenerwärmung über die Curietemperatur hinaus und damit verbunden durch die beträchtliche Widerstandszunahme den Stromfluß begrenzt.

In der DE—AS 27 17 826 ist eine Prüfeinrichtung zum Anzeigen einer elektrischen Spannung und/oder deren Polarität beschreiben, die auch zur Messung des Stromdurchganges durch einen elektrischen Leiter geeignet ist und bei der einer der Griffe eine Batterie mit vorgeschalteter Schutzdiode enthält und mit einem Tastschalter versehen ist, wobei die Schaltung so ausgelegt ist, daß eine Schutzdiode und die Batterie in Reihe geschaltet und mit einem einschaltbaren Kontakt des Tastschalters verbunden sind. Der andere Kontakt des Tastschalters überbrückt in Ruhestellung mittels einer Parallelleitung die Batterie und die Schutzdiode; schließlich ist diese Anordnung aus Tastschalter, Batterie und Schutzdiode mit der Antiparallelschaltung der Leuchtdioden in Reihe geschaltet.

Die Möglichkeit, mit einer einzigen Prüfeinrichtung sowohl das Vorhandensein einer elektrischen Spannung als auch deren Polarität und auch einen elektrischen Leiter auf Stromdurchgang zu prüfen, hat sich in der Praxis als zuverlässig und für viele Zwecke anwendbar bewährt.

Andererseits besteht das Bedürfnis, bei der Prüfung auf Vorliegen einer elektrischen Spannung auch ungefähre Angaben über die Höhe dieser Spannung zu erhalten. Bei hohen Spannungen ist es z.B. interessant, ob der Wert dieser Spannung bei 110, bei 220 oder bei 380 V liegt, während es bei niedrigeren Spannungen interessant zu wissen ist, ob die Spannung beispielsweise 3, 6, 12 oder 24 V beträgt. Es gibt zwar für diese Zwecke Meßgeräte, mit deren Hilfe der genaue Wert der Spannung gemessen werden kann, jedoch ist die Schaltung solcher Meßgeräte aufwendig, so daß der Preis eines solchen Gerätes hoch ist. Andererseits ist es in den meisten Fällen der Spannungsprüfung nicht erforderlich, den genauen Wert der Spannung zu ermitteln, weil die Aussage über einen Mindestwert der Spannung, der gerade eben überschritten wird, bereits dem Techniker für seine Arbeit mit elektrischen und elektronischen Geräten in der überwiegenden Zahl der Prüffälle ausreichend ist.

In der DE—OS 25 03 855 ist eine Schaltung für eine als Anzeigeeinheit dienende Leuchtdiodenkette beschrieben, wie sie beispielsweise zur Aussteuerung des Tonpegels an mehrkanaligen Mischpulten im Rahmen der Studio-Technik verwendet wird. Bei dieser bekannten Schaltung ist jeder der Leuchtdioden (LD1 ... LD10), die im Kreis eines auf konstanten Wert geregelten Stromes in Serie liegen, je ein zur Ansteuerung dieser zugeordneten Leuchtdiode (LD1) dienender Schalttransistor (T 1) parallelgeschaltet. Bei dieser Leuchtdiodenkette, bei der die Anzahl der eingeschalteten Leuchtdioden mit dem anzuzeigenden Wert gleichmäßig wächst, sind die Basen der Schalttransistoren (T 1) an die Ausgänge von Operationsverstärkern (OP 1) geschaltet, deren nichtinvertierende Eingänge (+) an je einem Abgriff eines Spannungsteilers (W1 ... W10) und deren invertierende Eingänge (—) gemeinsam an die anzuzeigende Spannung (U, M) gelegt sind.

Mit dieser Schaltung wird der Zweck erfüllt, eine einwandfreie Ansteuerung der Leuchtdioden, die gegenüber Spannungsüberhöhungen sehr empfindlich sind, zu erzielen, nämlich dadurch, daß der Strom, der alle jeweils eingeschalteten Dioden durchfließt, durch den Regler auf einen solchen Wert beschränkt bleibt, der für den Betrieb der Dioden notwendig ist, unabhängig davon, in welcher Reihenfolge und Anzahl die Dioden eingeschaltet werden. Der Regler besteht aus einem mit seiner Emitter-Kollektor-Strecke sowie mit einem Emitterwiderstand EW in den Stromkreis der Leuchtdiodenkette eingeschalteten Transistor, dessen Basis am Abgriff eines Spannungsteilers liegt. Im Stromkreis der Leuchtdiodenkette liegt außerdem eine Zenerdiode, welche ein sicheres Schalten der Transistoren gewährleisten soll.

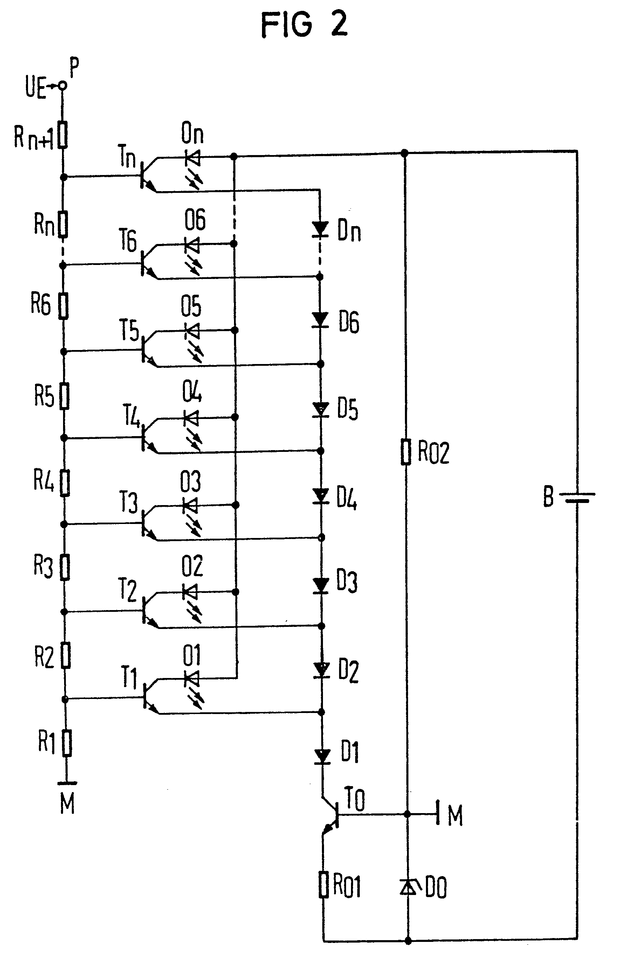

In der US—A—3 818 495 ist eine Schaltung und Gerät zur Anzeige des Belichtungswertes für fotografische Kameras beschrieben. Die Fig. 2 und die zugehörige Beschreibung in dieser Vorveröffentlichung lassen erkennen, daß mit den Teilerpunkten eines aus einer Reihenschaltung von Widerständen gebildeten Spannungsteilers Schaltungen in Form von Spannungsdiskriminatoren, beispielsweise ausgeführt als Schmitt-Trigger-Schaltung, verbunden sind, die als Ein- oder Ausschalter dienen, wenn eine Spannung anliegt, die oberhalb einer bestimmten Spannung liegen. Ein zugeschalteter Treiber (Inverter oder Puffer) bewirkt, daß die Ausgangsspannung niedriger oder höher ist, wenn er vom Spannungsdiskriminator beaufschlagt ist. Jede dieser einerseits mit je einem Teilerpunkt des Spannungsteilers verbundenen Diskriminatorschaltungen ist andererseits je mit einem Punkt zwischen zwei Leuchtdioden einer Leuchtdiodenkette verbunden. Bei dieser bekannten Schaltung ist nicht vorgesehen, daß die Emitter evtl. vorhandener Transistoren über die als Leuchtdioden ausgeführten nichtlinearen Anzeigeelementen so verbunden sind, daß die Transistoren untereinander gestaffelt jeweils als nichtlinear arbeitende Differenzverstärker wirken und ferner die Kollektoren der Transistoren untereinander verbunden sind und zu einer gemeinsamen Spannungsverorgung führen. Die vorliegende Erfindung unterscheidet sich grundsätzlich von der bekannten Schaltung u.a. durch diese Schaltung der Transistoren.

In der US—A—3 555 420 ist eine Prüfeinrichtung zum Anzeigen einer elektrischen Spannung und ggf. deren Polarität beschrieben, die aus zwei durch ein Kabel verbundenen, mit Kontaktspitzen versehenen Griffen besteht und in einem dieser Griffe optische Anzeigeelemente enthält. Bei dieser bekannten Prüfeinrichtung sind wenigstens zwei Anzeigestufen zusammengeschaltet, die jeweils eine Zusammenschaltung wenigstens von einem Widerstand und einem optischen Anzeigeelement umfassen. Die Schaltung, die in dieser Prüfeinrichtung verwirklicht ist, ermöglicht zwar, daß die Anzeigestufen derart zusammenwirken, daß die anliegende Spannung nach deren in einem gewählten Spannungsbereich liegenden Wert unterschieden und entsprechend den gewählten Spannungsbereichen gestaffelt angezeigt wird, jedoch sind bei dieser Schaltung in den einzelnen Anzeigestufen Transistoren nich vorgesehen, so daß auch eine Verschaltung solcher Transistoren entsprechend der vorliegenden Erfindung nicht nahegelegt wird.

Es ist die Aufgabe der vorliegenden Erfindung, ein Prüfgerät zum Anzeigen einer elektrischen Spannung anzugeben, das durch einfache Schaltung und durch Verwendung kostengünstiger Bauelemente dem obengenannten Bedürfnis voll entspricht; das Gerät soll in der Handhabung ebenso einfach sein wie die oben beschriebenen bekannten Prüfeinrichtungen und auch ohne Umschaltung über einen weiten Spannungsbereich funktionsfähig bleiben; es ist Teil der Aufgabenstellung, daß bei der Prüfeinrichtung der für die Anzeigeelemente erforderliche Strom nicht durch die Widerstände des Meßteilers fließen Muß; im Vordergrund der Aufgabenstellung steht weiterhin, daß der Strombedarf der Prüfeinrichtung möglichst klein ist, um bei Verwendung einer auswechselbaren Batterie deren normale Lebensdauer möglichst voll auszunützen oder um bei von der Prüfspannung versorgten Prüfgeräten den Innenwiderstand der gesamten Anordnung vergleichsweise hoch halten zu können.

Zur Lösung dieser Aufgabe ist die Prüfeinrichtung der eingangs angegebenen Art erfindungsgemäß durch die Merkmale des Patentanspruches 1 gekennzeichnet.

Weitere Lösungen dieser Aufgabe sind erfindungsgemäß durch die Merkmale der Patentansprüche 2, 3 oder 4 gekennzeichnet.

Bevorzugte Ausführungsformen der Erfindung sind durch die Merkmale der Unteransprüche 5 bis 11 gekennzeichnet.

Die Vorteile der vorliegenden Erfindung werden nachfolgend anhand der beigefügten Figuren erläutert.

Es zeigen

Fig. 1 den prinzipiellen Schaltungsaufbau mit Transistoren für additive Anzeige der anzuzeigenden Meßspannung,

Fig. 2 den prinzipiellen Schaltungsaufbau mit Transistoren für alternierende Anzeige der anzuzeigenden Meßspannung,

Fig. 3 ein konkretes Ausführungsbeispiel für eine Prufeinrichtung, mit der die Anzeige sowohl unterschiedlicher Bereiche als auch der Polarität der Spannung möglich ist,

Fig. 4 eine andere konkrete Ausführungsform, bei der die Spannungen im unteren Spannungsbereich mittels Leuchtdioden, Spannungen im oberen Spannungsbereich mittels Glimmlampen und die Polarität ebenfalls mit Leuchtdioden angezeigt werden können,

Fig. 5 eine Ausführung der Schaltung gemäß Fig. 1 unter Verwendung von Operationsverstärkern,

Fig. 6 eine Ausführung der Schaltung gemäß Fig. 2 mit Operationsverstärkern.

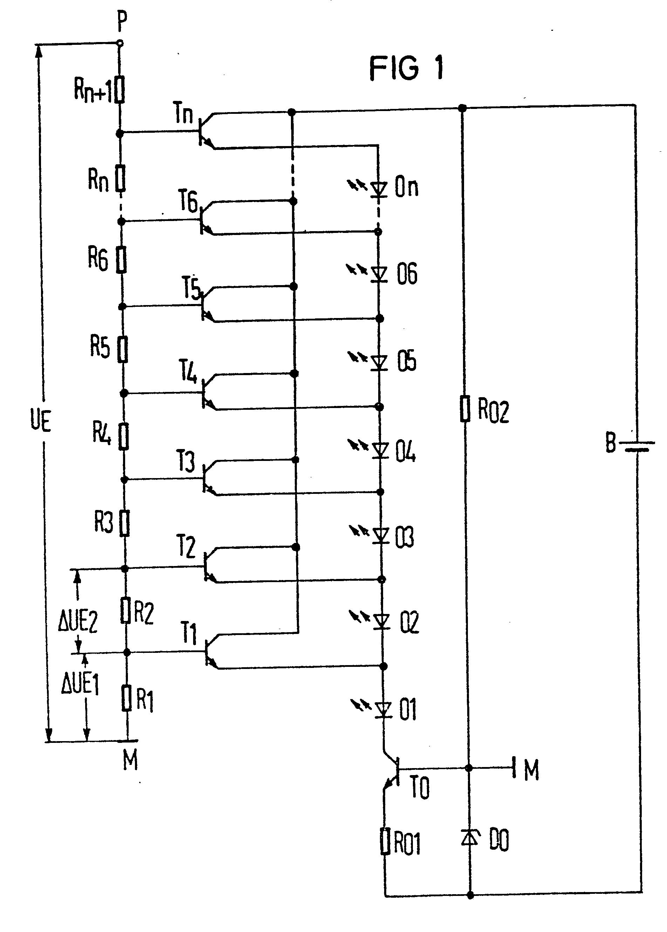

In der Schaltung nach Fig. 1 sind die Widerstände R1 bis Rn + 1 als Meßteiler geschaltet, Zwischen dem Punkt P, der bei der Ausführung dieser Schaltung innerhalb einer also Griff ausgebildeten Prüfeinrichtung (vgl. z.B. DE—PS 20 60 884, DE—AS 27 17 826, DE—AS 26 35 374 oder DE—GM 77 24 448) die Prüfspitze darstellt, und dem Bezugspunkt M, der bei einpoliger Schaltungsausführung (der Prüfstrom geht in diesem Falle durch den menschlichen Körper gegen Erde) von einem Finger der Prüfperson berührt wird bzw. bei zweipoliger Ausführung in einem zweiten Griff — der mit dem ersten Griff durch ein Kabel verbunden ist — die zweite Prüfspitze darstellt, liegt die Spannung UE. An den einzelnen Teilerpunkten des Meßteilers zwischen je zwei Widerständen R1 und R2 bzw. R2 und R3 bzw. Rn und Rn + 1 ist jeweils die Basis eines der also Trennverstärker T dienenden Transistoren T1 bis Tn zugeschaltet. Die Emitter dieser Transistoren T1 bis Tn sind über die Anzeigeelements O1 bis On, vorzugsweise als Leuchtdioden LED ausgeführt, so verbunden, daß die Transistoren T1 bis Tn untereinander gestaffelt als nichtlinear arbeitende Differenzverstärker wirken, indem die Emitter jeweils zweier aufeinanderfolgender Transistoren über das nichtlineare Anzeigeelement O1 bis On verbunden werden. Die Kollektoren der als Trennverstärker dienenden Transistoren T1 bis Tn sind untereinander verbunden und zu einer gemeinsamen Spannungsversorgung geführt. Für die Betriebsspannung ist in den Stromkreis zur Versorgung der Transistoren T1 bis Tn hier eine Batterie B geschaltet. Die Stromversorgung für die Anzeigeelemente O1 bis On wird durch eine Konstantstromquelle TO angesteuert, die den durch die einzelnen Transistoren T1 bis Tn der Anzeigestufen fließenden Strom begrenzt. Die Konstantstromquelle TO ist durch eine Kontantspannungsquelle in Form einer Zenerdiode DO realisiert, die durch einen Widerstand RO1 einen konstanten Treiberstrom erzeugt. Die Zenerdiode DO ist über einen Widerstand RO2 angeschlossen und die Basis des Transistors TO ist auf den gemeinsamen Bezugspunkt M besogen.

Die Schaltung nach Fig. 1 funktioniert wie folgt.

Die Eingangsspannung UE wird über den linearen Spannungsteiler R1 bis Rn + 1 durch Bemessung der Widerstände R1 bzw. R2 bzw. Rn so geteilt, daß bei Steigerung der Klemmenspannung beim Schwellwert UE1 (unterste anzuziehende Stufenspannung) der Spannungsabfall $\Delta$UE1 an R1 einen Wert erreicht, bei dem die Emitter-Basis-Spannung des Transistors T1 und die Durchlaßspannung der Leuchtdiode O1 erreicht wird. Der Transistor T1 wird ab dieser Schwellspannung eingeschaltet, sein Emitterstrom wird vom Transistor TO der Konstantstromquelle bestimmt. Steigt die Klemmenspannung UE weiter an, liegt also in der Praxis z.B. der anzuzeigende Schwellwert UE2 vor, so wird dann, wenn der Spannungsabfall $\Delta$UE2 an R2 gleich der Durchgangsspannung der Leuchtdiode O2 wird, der Transistor T2 leitend. Da sein Emitter als Spannungsquelle gilt, wird jetzt das Potential zwischen den Leuchtdioden O1 und O2 durch den Emitter von T2 bestimmt und damit der Transistor T1 rückwärts gesperrt, da das Potential zwischen den Leuchtdioden O1 und O2 schneller steigt als das Basispotential an T1.

In dem Maße also, in dem T2 den durch TO begrenzten Strom übernimmt, nimmt der Strom durch den Kollektor des Transistors T1 ab, bis der Transistor T1 stromlos ist. Nach diesem allgemeinen Prinzip wird, sofern die Widerstände R1 bis Rn so bemessen werden, daß bei Erreichen der jeweiligen Stufenspannung UE1 bis UEn jeweils der Spannungsabfall an den einzelnen Widerständen R1 bis Rn der Durchlaßspannung an den Leuchtdioden O1 bis On entspricht, jeweils nur einer der Transistoren T1 bis Tn eingeschaltet, nämlich nur der, der der jeweiligen Eingangsspannung UEn entspricht.

Die Anzeigeelemente O1 bis On sind in Reihe geschaltet und werden deshalb additiv eingeschaltet. Hieraus resultiert der Vorteil dieser Schaltung, daß jeweils der Gleiche Anzeigestrom der Stromquelle entnommen wird, da die Stromquelle TO immer nur den Strom IO abgibt, der durch die Zenerdiodenspannung abzüglich der Emitter-Basis-Spannung von TO, geteilt durch den Widerstand RO1 bestimmt wird.

In der Schaltung gemäß Fig. 2, in der gleiche Teile wie in Fig. 1 auch mit gleichen Bezugszeichen versehen sind, sind die Anzeigeelemente O1 bis On jeweils direkt an die zugehörigen Kollektoren der Transistoren T1 bis Tn geschaltet. Zwischen den Emittern der einzelnen Transistoren T1 bis Tn sind Stufendioden D1 bis Dn geschaltet. Dadurch entsteht eine alternierende Anzeige, denn nur die zum jeweiligen Spannungswert gehörende Anzeigestufe wird zum Leuchten gebracht, während alle anderen Anzeigestufen verlöschen.

Auch bei der Schaltung gemäß Fig. 2 ist für die Betriebsspannung eine Batterie B in den Stromkreis zur Versorgung der Transistoren T1 bis Tn und der Anzeigeelemente O1 bis On, vorzugsweise in Form von Leuchtdioden, vorgesehen.

Die Konstantstromquelle und ihre Wirkungsweise ist bei Fig. 1 beschrieben.

Bei der Schaltung gemäß Fig. 2 sind an den Stellen, an denen bei der Schaltung gemäß Fig. 1 die Anzeigeelemente O1 bis On, vorzugsweise in Form von Leuchtdioden vorgesehen sind, normale Dioden D1 bis Dn verwendet. Die Emitter der Transistoren T1 bis Tn sind dann jeweils zwischen die normalen Dioden D1 bis Dn geschaltet.

In jedem Falle kommt es bei der Schaltung gemäß Fig. 2 zu einer alternierenden Anzeige, weil die Anzeigeelemente O1 bis On mit den Kollektoren der Transistoren T1 bis Tn verbunden sind, so daß nur jeweils die als Anzeigeelement verwendete Leuchtdiode im Kollektor des jeweils eingeschalteten Transistors anzeigt, während die anderen Anzeigeelemente nicht aufleuchten.

Die Staffelung der Widerstände R1 bis Rn kann in gleichen Stufen vorgenommen werden, so daß die Eingangsspannung in äquidistanten Spannungsschritten angezeigt wird. Die Staffelung kann aber auch beliebig, den jeweiligen Anforderungen angemessen vorgenommen sein. Vorteilhaft ist es, die Spannungsschritte logarithmisch vorzunehmen, um den Fehlerbereich pro Stufe relativ gleich zu halten.

In den Figuren 1 und 2 sind Schaltungen gezeigt, die mit Batteriebetrieb arbeiten und es gestatten, schon relativ kleine Spannungen anzuzeigen bzw. die Einrichtung hochohmig auszugestalten und somit als einpoliges Gerät auszubilden.

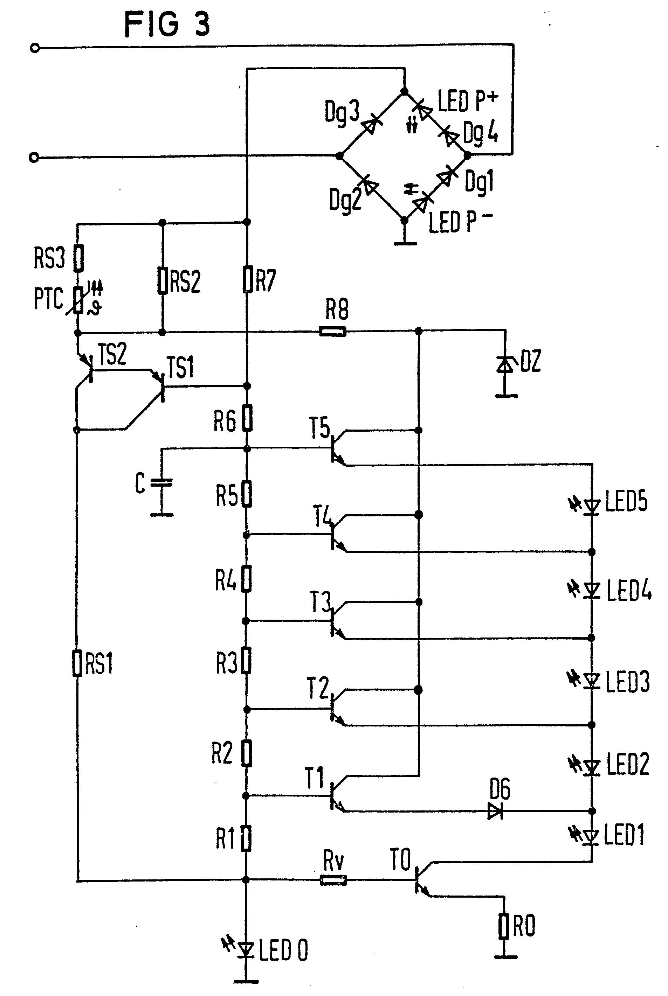

Fig. 3 zeigt eine Schaltung, die es gestattet, sowohl Gleich- als auch Wechselspannung nach Wert und Polarität zu unterscheiden. Als Anzeigeelemente sind hier Leuchtdioden LED vorgesehen, wobei die Schaltung die Möglichkeit liefert, einzelnen dieser Leuchtdioden Mehrfachfunktionen zuzuordnen.

In der Schaltung gemäß Fig. 3 ist ein Graetz-Gleichrichter vorgesehen, der aus vier Dioden Dg1 ... Dg4 besteht. Im Brückenzweig dieses Gleichrichters befinden sich noch zwei weitere Leuchtdioden LED P$^-$ und LED P$^+$, die es gestatten, bei Gleichspannung die Polarität (−) oder (+) sowie eine Wechselspannung durch Aufleuchten beider Leuchtdioden (LED P$^-$ und LED P$^+$) anzuzeigen.

Ferner befindet sich in der Schaltung gemäß Fig. 3 ein Anzeigenteil, dessen Schaltung in Fig. 1 bereits prinzipiell dargestellt und dabei beschrieben ist. Der Anzeigenteil besteht aus einem Spannungsteiler aus Widerständen R1 bis R7. Zwischen jeweils zwei Widerständen sind die Basen von als Trennverstärker arbeitenden Transistoren TO, T1 bis T5 geschaltet, deren Emitter zwischen jeweils zwei Leuchtdioden LED0, LED1 bis LED5 einer Leuchtdioden-Reihenschaltung geschaltet sind und deren Kollektoren untereinander verbunden sind und zu einer gemeinsamen Spannungsversorgung führen. Zur Stromversorgung der Transistoren TO, T1 bis T5 sind zwei in Darlington-Konfiguration geschaltete Transistoren Ts1 und Ts2 vorgesehen. Zum Schutze der Schaltung vor extrem hohen Meßspannungen ist zwischen der Eingangsspannung und dem Emitter des Transistors Ts2 eine Reihenschaltung aus einem keramischen Kaltleiter PTC und einem Festwiderstand Rs3 vorgesehen. Für die Stromversorgung ist ferner ein Widerstand Rs1 der Darlington-Konfiguration aus den Transistoren Ts1 und Ts2 zugeschaltet. Parallel zur Reihenschaltung aus dem keramischen Kaltleiter PTC und dem Widerstand Rs3 ist ein weiterer Widerstand Rs2 geschaltet. Der Transistor TO ist über den Vorwiderstand Rv gleichzeitig auch die Konstantstromquelle, für die die Leuchtdiode LED0 die Konstantspannungsquelle bildet, die ihrerseits gleichzeitig auch Anzeigeelement für eine untere Spannungsstufe ist.

Die Zuordnung unterschiedlicher Funktionen für einige Leuchtdioden bringt eine Ersparnis an Aufwand und eine Vereinfachung der gesamten Einrichtung mit sich.

Die Transistoren Ts1 und Ts2 bewirken eine zur Eingangsspannung proportionale Spannungsversorgung der Schalttransistoren T1 bis T5.

Durch die Reihenschaltung aus einem keramischen Kaltleiter PTC und einem normalen Widerstand Rs3 wird bein sehr hoher Eingangsspannung der durch den Transistor Ts2 fließende Strom begrenzt, da sich der keramische Kaltleiterwiderstand aufheizt und mit seinem Widerstandswert entsprechend stark zunimmt. Da ferner das Potential an der Basis des Transistors Ts1 proportional zur Eingangsspannung über den linearen Spannungsteiler R1 bis R7 steigt, folgt der Emitter des Transistors Ts2 der Eingangsspannung entsprechend dem Teiler-Verhältnis. Der durch den Transistor Ts2 fließende Strom wird jedoch, bedingt durch den Kaltieterwiderstand PTC begrenzt, so daß die Leuchtdiode LED0 einen begrenzten Strom erhält. Gleichzeitig wird, um die Kollektor-Emitter-Spannungsgrenze des Transistors TO nicht zu übersteigen, die Kollektorspannung durch die Zenerdiode Dz begrenzt, falls die Eingangsspannung UE zu groß word. Am Widerstand R8 fällt dann der überhöhte Spannungsanteil ab.

Der Widerstand RO ist Teil der Konstantspannungsquelle. Die Diode D6 hat Schutzfunktionen.

Die hier dargestellte Schaltung wurde in einer Prüfeinrichtung für die nachfolgend angegebenen Spannungsstufen realisiert, wobei bei Gleichspannung nicht nur die Spannungsstufe, sondern auch die Polarität angezeigt wird und bei Wechselspannung beide für die Polaritätsanzeige vorgesehenen Leuchtdioden LED P$^+$ und LED P$^-$ aufleuchten.

Bei einer Spannung, die 6 V beträgt oder überschreitet, leuchtet im Falle von Gleichspannung die Leuchtdiode LED P$^+$ auf, wenn die Prüfspitze P der Einrichtung am positiven Pol anliegt. Liegt die Prüfspitze P am negativen Pol an, dann zeigt die Luechtdiode LED P$^-$ an. Die gleiche Anzeige der Polarität tritt auch bei Gleichspannungen in den Spannungsstufen ab 12, 24, 50, 110 und ab 380 V auf. Bei Wechselspannung, z.B. bei 220 V Wechselspannung, leuchten beide der Polaritätsanzeige dienenden Leuchtdioden LED P$^+$ und LED P$^-$ sowie die Leuchtdioden LED0 und LED1 bis LED4 auf.

Die Spannungsstufen sind wie folgt eingeteilt:

$$UE = 6 \text{ V} \simeq (\text{LED P}^+/\text{LED P}^-) \text{ und Polaritäts-}$$
$$\text{anzeige}$$
$$UE = 12 \text{ V} \simeq (\text{LED0})$$

$$UE = 24\ V \simeq (LED1)$$
$$UE = 50\ V \simeq (LED2)$$
$$UE = 110\ V \simeq (LED3)$$
$$UE = 220\ V \simeq (LED4)$$
$$UE = 380\ V \simeq (LED5)$$

Der Kondensator C in der Schaltung läßt sich so bemessen, daß aufgrund der hohen Widerstände R7 und R6 mit C ein Integrator gebildet wird, der die zweiweggleichgerichtete Eingangsspannung dem Wert für Eingangsgleichspannungen in den jeweiligen Schwellenwerten gleichsetzt und ist beispielsweise für 50/60 Hz dimensioniert.

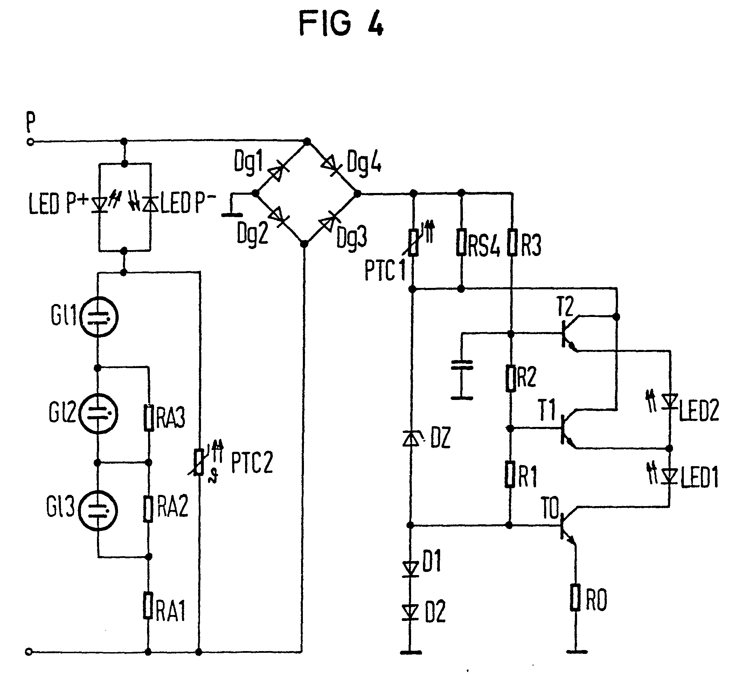

In Fig. 4 ist eine Schaltung für eine Prüfeinrichtung gezeigt, bei der zur Anzeige von niedrigen Spannungen (beispielsweise von 3 bis 50 V und noch geringfügig darüber) in den zugehörigen Anzeigestufen Transistoren T0, T1 und T2 und Leuchtdioden LED1 und LED2 vorgesehen sind. Der keramische Kaltleiter PTC1 dient zur Strombegrenzung für die Anzeigestufen mit den aktiven Bauelementen.

Der dem keramischen Kaltleiter PTC1 parallelgeschaltete Widerstand Rs4 dient zur Stromversorgung. Diesem Widerstand Rs4 ist ein Widerstand R3 parallelgeschaltet, der zu dem aus drei Widerständen R1 bis R3 bestehenden Meßteiler gehört. An den Teilerpunkten dieses Meßteilers liegen die Basen der Transistoren T0, T1 und T2 für die Anzeigestufen mit den Leuchtdioden LED1 und LED2. Die Funktionsweise dieser Anzeigestufen ist bei der Schaltung gemäß Fig. 1 beschrieben. Zusammen mit dem Widerstand R0 dient der Transistor T0 gliechzeitig als Konstantstromquelle. In dem Anzeigeteil für niedrige Spannungen sind ferner die Zenerdiode Dz und die Schutzdioden D1 und D2 vorgesehen.

Zur Gleichrichtung dient ein aus vier Dioden Dg1 bis Dg4 bestehender Graetz-Gleichrichter, der dem Anzeigenteil für niedrige Spannungen vorgeschaltet ist.

Der keramische Kaltleiter PTC2 ist dem Graetz-Gleichrichter als Schutzglied vorgeschaltet und dient gleichzeitig der Strombegrenzung für die Leuchtdioden LED P$^+$ und LED P$^-$, die zur Anzeige der Polarität bei Gleichspannungen und gleichzeitig auch zur Anzeige der untersten Spannungsstufe dienen. Diese beiden Leuchtdioden sind antiparallel geschaltet. Der keramische Kaltleiter PTC2 liegt zu dieser Anti-parallelschaltung in Reihe.

Die Antiparallelschaltung der Leuchtdioden LED P$^+$ und LED P$^-$ ist ferner einem Anzeigenteil für hohe Spannungen (etwa ab 110 V und mehr) vorgeschaltet, der aus in Reihe geschalteten Glimmlampen Gl1 bis Gl3 und aus einem dazu parallelgeschalteten Meßteiler aus den Widerständen RA1 bis RA3 besteht.

Die Schaltung gemäß Fig. 4 funktioniert in der Weise, daß für die unteren Anzeigestufen, beispielsweise für 6, 12 und 24 V die Leuchtdioden LED P$^+$ und LED P$^-$ sowie LED1 und LED2 vorgesehen sind. Bei 6 V und etwas darüber leuchtet bei Gleichspannung die Leuchtdiode LED P$^+$, wenn die Prüfspitze P am positiven Pol anliegt. Liegt die Prüfzpitze P bei einer zu prüfenden Gleichspannung am negativen Pol an, so leuchtet die Leuchtdiode LED P$^-$ auf. Bei Spannungen, die 12 V übersteigen, leuchtet ferner die Leuchtdiode LED1 auf, u.zw. zusätzlich zu den Leuchtdioden Led P$^+$ und/oder Led P$^-$ (bei Wechselspannungen leuchten beide Leuchtdioden LED P$^+$ und LED P$^-$ auf). Übersteigt die zu prüfende Spannung 24 V, so leuchtet auch noch die Leuchtdiode LED2 auf.

Der Anzeigenteil für untere Spannungsstufen ist durch den keramischen Kaltleiter PTC1 vor Überspannungen geschützt.

Der Anzeigenteil für höhere Spannungen ist nur für das Prüfen von Wechselspannungen geeignet. In diesem Falle leuchten beide Leuchtdioden LED P$^+$ und LED P$^-$ sowie bei z.B. 110 V Wechselstrom die Glimmlampe Gl1 und die LED1 und LED2 auf. Bei 220 V Wechselstrom bzw. bei 380 V Wechselstrom leuchten zusätzlich die Glimmlampen Gl2 (220 V) bzw. Gl2 und Gl3 (380 V) auf.

Die Zenerdiode Dz und die Dioden D1 und D2 üben entsprechende Funktionen aus, wie sie bei der Schaltung gemäß Fig. 3 bereits beschrieben sind.

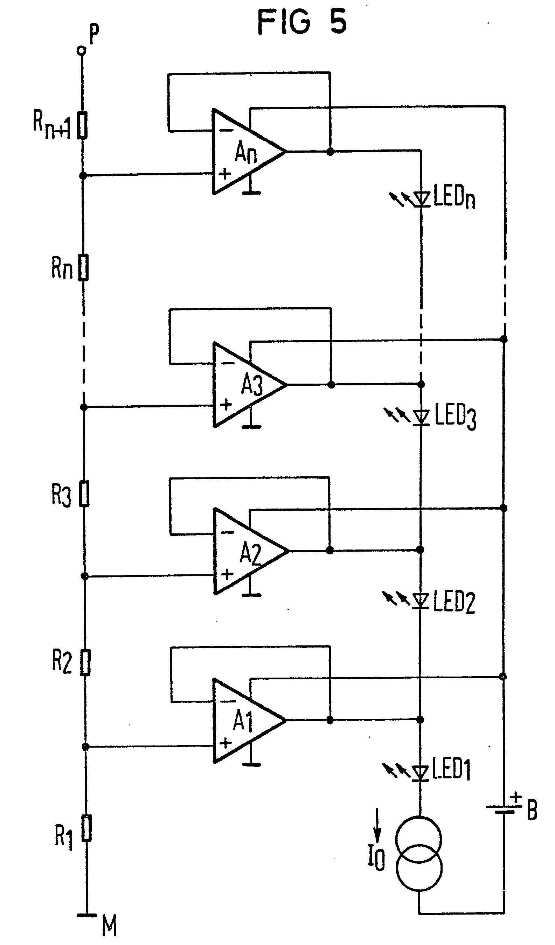

Fig. 5 zeigt ein additives Netzwerk, aufgebaut mit Operationsverstärkern A1 bis An und einer Batterie B als Spannungsquelle. An dem Prüfspannungsteiler R1 bis Rn + 1 liegen zwischen den jeweiligen Teilerwiderständen die nichtinvertierenden (gekennzeichnet mit +) hochohmigen Eingänge der Verstärker A1 bis An. Diese sind hier prinzipiell vom invertierenden Eingang (gekennzeichnet mit —) mit dem Ausgang kurzgeschlossen, haben also die Verstärkung 1. An ihrem Ausgang liegen ebenfalls die Leuchtdioden LED1 bis LEDn in gestaffelter Reihenfolge derart, daß die Ausgänge der Operationsverstärker A1 bis An zwischen jeweils zwei Leuchtdioden geführt sind. Die Leuchtdioden LED1 bis LEDn und damit die Ausgänge der Operationsverstärker A1 bis An werden von einer Stromkonstantquelle I0 gespiest, die hier durch das prinzipielle Schaltbild dargestellt ist und entweder durch Transistoren oder auch durch Operationsverstärker realisiert werden kann. In der Schaltung nach Fig. 5 werden die Operationsverstärker A1 bis An durch die Batterie B versorgt. Die Wirkungsweise der Schaltung ist folgende:

Wird an den Eingang P eine positive Klemmenspannung UE gelegt, so steigt das Potential an den Teilerwiderständen R1 bis Rn mit steigender Klemmenspannung an. Wird der hierdurch erzeugte proportionale Spannungsabfall an R1 so groß, daß der gleichlaufende Ausgang von A1 eine Spannungshöhe erreicht, die der Ansprechdurchgangsspannung von LED1 entspricht, so leuchtet die Leuchtdiode LED1 ab einer durch die Größe des Spannungsteilers bestimmten Schwellspannung UE1 auf.

Der Strom durch diese Leuchtdiode steigt bis zu dem Wert I0 an. Bei weiter steigender Klemmenspannung UE bis zum Wert von UE2, der zweiten Schwellspannung, ist der Spannungsabfall an R2 so groß, daß er ebenfalls der Leuchtdiodenansprechspannung entspricht, dann schaltet die Leuchtdiode LED2 durch, da der Ausgang von A2 der Teilerspannung zwischen R2 und R3 folgt.

Da nun A2 das Potential an LED2 und damit auch das Potential am Ausgang von A1 bestimmt und damit das Potential am invertierenden Eingang von A1 ebenfalls festgelegt wird, schaltet der Verstärker A1 ab und wird stromlos, da sein Minus-Eingang ein höheres Potential führt als sein Plus-Eingang, denn bei steigender Eingangsklemmenspannung UE steigt das Potential über R1 + R2 mit größerer Änderung an als an R1. Da LED1 und LED2 in Reihe geschaltet sind, leuchten beide Anzeigeelemente mit gleicher Helligkeit, da durch sie der Gleiche Strom fließt (additive Anzeige).

Für die dritte Stufe dieser Anzeige gilt der analoge Vorgang bei weiterer Steigerung der Eingangsspannung bis zum Schwellpunkt UE3. Dann nämlich schaltet A3 den Verstärker A2 ab und die Leuchtdiode LED3 schaltet sich additiv zu den schon in Betrieb befindlichen LED1 und LED2. Nach diesem Prinzip kann das Netzwerk mit beliebig vielen Anzeigestufen aufgebaut werden. Sein Vorteil gegenüber allen bisher behandelten Netzwerken liegt vor allem darin, daß die Eingangswiderstände der Operationsverstärker, verglichen mit Transistoren, um einige Zehnerpotenzen höherliegen und demzufolge der Verstärkereingangsstrom in dem Meßteiler vernachlässigt werden kann. Das hat den Vorteil, daß der Meßteiler sehr hochohmig werden kann und ohne Schwierigkeit Werte von einigen Mega-Ohm erreicht. Sofern die Spannungsversorgung der Schaltung mit einer Batteriespannung vorgenommen wird oder einer anderen von der Prüfspannung getrennten Spannungsquelle, können hierdurch die bei hochwertigen Meßinstrumenten üblichen Eingangswiderstände erreicht werden, die es gestatten, die Prüfspannung praktisch leistungslos zu messen.

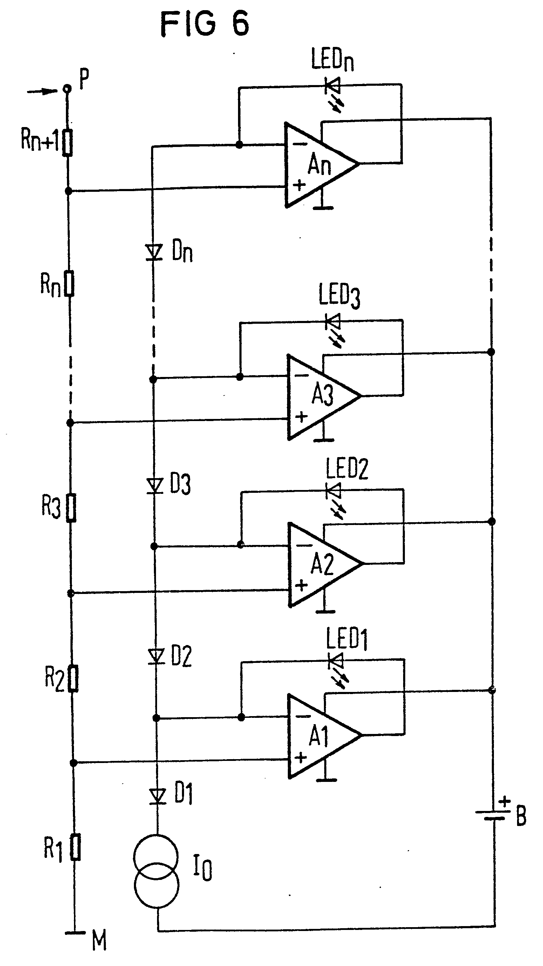

Fig. 6 zeigt, entsprechend der Alternative von Fig. 2 zu Fig. 1, eine Alternative zu der Schaltung gemäß Fig. 5, bei der ein alternierendes Netzwerk mit Operationsverstärkern A1 bis An vorliegt, also eine Schaltung, bei der die einzelnen Leuchtdioden LED1 bis LEDn auch gestaffelt aufeinanderfolgend mit der Eingangsspannung aufleuchten, bei der aber jeweils nur eine Leuchtdiode für einen gewissen Spannungsbereich in Betrieb ist. Auch hier liegen die nichtinvertierenden Eingänge (gekennzeichnet mit +) der Operationsverstärker A1 bis An an den Teilerpunkten eines Meßspannungsteilers R1 bis Rn + 1. Im Rückkopplungszweig der Operationsverstärker liegen die Leuchtdioden LED1 bis LEDn. Die invertierenden Eingänge (gekennzeichnet mit −) der Operationsverstärker A1 bis An liegen an übereinander gestaffelt geschalteten Dioden D1 bis Dn, jeweils zwischen zwei Dioden.

Erreicht die zu prüfende Klemmenspannung UE ihren ersten Stufenwert UE1, dann wird der Spannungsabfall an R1 so groß, daß die Durchlaßspannung von D1 erreicht wird und die Leuchtdiode LED1 aufleuchtet, da sich im Ausgang des Verstärkers A1 eine Spannung aufbaut, um den durch die Konstantstromquelle I0 bestimmten Strom zur Verfügung zu stellen. Bei weiter steigender Klemmenspannung bis zum Schwellwert UE2 wird der Spannungsabfall an R2 so groß, daß an dem invertierenden Eingang von A2 durch den Ausgang dieses Operationsverstärkers eine Spannung zur Verfügung gestellt wird, die gleich der Teilerspannung zwischen R2 und R3 ist. Wird R2 so bemessen, daß die Spannungsdifferenz zwischen UE2 und UE1 gerade an R2 einen Spannungsabfall erzeugt, der der Durchgangsspannung von D2 bei I0 entspricht, so wird bei diesem Wert LED2 zur Anzeige gebracht. Da die Änderung des Potentials an (R1 + R2) größer ist als an R1, folgt somit, daß das Potential am invertierenden Eingang von A2 schneller steigt als am nichtinvertierenden Eingang von A1. Da aber der invertierende Eingang von A2 über die Diode D2 mit dem invertierenden Eingang von A1 verbunden ist, wird A1 wieder abgeschaltet, da sein Minus-Eingang positiver wird also sein Plus-Eingang. Analog zur stufenweisen Einschaltung von A1 und A2 erfolgt die stufenweise Einschaltung von A3 und die hierdurch bedingte Abschaltung der darunterliegenden Stufe A2. Es ist evident, daß diese Folge auch für alle nachgeschalteten Stufen bis An gültig ist.

Es ist offensichtlich, daß die Anzeigestufen in den Schaltungen gemäß den Figuren 3 und 4 entsprechend mit Operationsverstärken aufgebaut sein können, wie dies in den Figuren 5 und 6 dargestellt und beschrieben ist.

Die Widerstände des Spannungsteilers und die Transistoren bzw. Operationsverstärker können vorzugsweise in einen Baustein integriert sein.

**Patentansprüche**

1. Prüfeinrichtung zum stufenweisen Anzeigen einer Meßspannung (UE), die zwei mit Kontaktspitzen versehene Griffe umfaßt, die durch ein Kabel verbunden sind und von denen einer eine Anzeigeeinheit aufnimmt, die eine Reihenschaltung aus nichtlinearen Leuchtelementen (O1—On) sowie einen Spannungsteiler aus mehreren in Reihe geschalteten Widerständen (R1—Rn + 1) enthält, der von der Meßspannung beaufschlagt ist, dadurch gekennzeichnet, daß jeweils an jeden der von den Verbindungspunkten der Widerstände (R1—Rn + 1) gebildeten Abgriffe des Spannungsteilers die Basis je eines Transistors (T1—Tn) angeschlossen ist, dessen Emitter jeweils mit der einen Klemme je eines der Leuchtelemente (O1—On) und dessen Kollektor jeweils mit den Kollektoren der übrigen Transistoren sowie mit einer Klemme einer Stromversorgung (B, TO, RO1, DO) verbunden ist, deren andere Klemme an die andere Klemme des Leuchtelementes (O1) am Ende der Reihenschaltung angeschlossen ist.

2. Prüfeinrichtung zum stufenweisen Anzeigen einer Meßspannung ($U_E$), die zwei mit Kontaktspitzen versehene Griffe umfaßt, die durch ein Kabel verbunden sind und von denen einer eine Anzeigeeinheit aufnimmt, die eine Reihenschaltung aus nichtlinearen Leuchtelementen (O1—On) sowei einen Spannungsteiler aus mehreren in Reihe geschalteten Widerständen (R1—Rn + 1) enthält, der von der Meßspannung beaufschlagt ist, dadurch gekennzeichnet, daß jeweils an jeden der von den Verbindungspunkten der Widerstände (R1—Rn + 1) gebildeten Abgriffe des Spannungsteilers je ein Operationsverstärker (A1—An) mit seinem nichtinvertierenden Eingang angeschlossen ist, dessen Ausgang jeweils mit der einen Klemme je eines der Leuchtelemente (LED1—LEDn) sowie jeweils mit dem invertierenden Eingang des betreffenden Operationsverstärkers verbunden ist und daß eine Stromversorgung (B, IO) vorgesehen ist, die mit ihrer einen Klemme jeweils an einen Versorgungseingang eines jeden Operationsverstärkers und die mit ihrer anderen Klemme an die andere Klemme des Leuchtelements (LED1) am Ende der Reihenschaltung angeschlossen ist.

3. Prüfeinrichtung zum stufenweisen Anzeigen einer Meßspannung ($U_E$), die zwei mit Kontaktspitzen versehene Griffe umfaßt, die durch ein Kabel verbunden sind und von denen einer eine Anzeigeeinheit aufnimmt, die eine Anzahl von nichtlinearen Leuchtelementen (O1—On) sowie einen Spannungsteiler aus mehreren in Reihe geschalteten Widerständen (R1—Rn + 1) enthält, der von der Meßspannung beaufschlagt ist, dadurch gekennzeichnet, daß jeweils an jeden der von den Verbindungspunkten der Widerstände (R1—Rn + 1) gebildeten Abgriffe des Spannungsteilers die Basis je eines Transistors (T1—Tn) angeschlossen ist, dessen Kollektor jeweils mit der einen Klemme je eines der Leuchtelemente (O1—On) verbunden ist, daß eine Reihenschaltung von nichtlinearen Schaltelementen (D1—Dn) vorgesehen ist, deren jeweils eine Klemme an den Emitter je eines der Transistoren (T1—Tn) angeschlossen ist, und daß eine Stromversorgung (B, TO, RO1, DO) vorgesehen ist, die mit ihrer einen Klemme jeweils an die andere Klemme eines jeden Leuchtelements und die mit ihrer anderen Klemme an die andere Klemme des nichtlinearen Schaltelements (D1) am Ende der Reihenschaltung angeschlossen ist.

4. Prüfeinrichtung zum stufenweisen Anzeigen einer Meßspannung ($U_E$), die zwei mit Kontaktspitzen versehene Griffe umfaßt, die durch ein Kabel verbunden sind und von denen einer eine Anzeigeeinheit aufnimmt, die eine Anzahl von nichtlinearen Leuchtelementen (LED1—LEDn) sowie einen Spannungsteiler aus mehreren in Reihe geschalteten Widerständen (R1—Rn + 1) enthält, der von der Meßspannung beaufschlagt ist, dadurch gekennzeichnet, daß jeweils an jeden der von den Verbindungspunkten der Widerstände (R1—RN + 1) gebildeten Abgriffe des Spannungsteilers der nichtinvertierende Eingang je eines Operationsverstärkers (A1—An) angeschlossen ist, daß eine Reihenschaltung aus nichtlinearen Schaltelementen (D1—Dn) vorgesehen ist, wobei die eine Klemme dieser Schaltelemente jeweils an den invertierenden Eingang je eines der Operationsverstärker (A1—An) angeschlossen ist, daß der Ausgang eines jeden Operationsverstärkers über jeweils eines der Leuchtelemente (LED1—LEDn) auf den invertierenden Eingang rückgekoppelt ist, und daß eine Spannungsversorgung (B, IO) vorgesehen ist, deren eine Klemme jeweils an einen Versorgungseingang eines jeden Operationsverstärkers (A1—An) und deren andere Klemme an die andere Klemme des nichtlinearen Schaltelements (D1) am Ende der Reihenschaltung angeschlossen ist.

5. Prüfeinrichtung nach einem der vorhergehenden Ansprüche, dadurch gekennzeichnet, daß die Stromversorgung eine Konstantstromquelle (TO, RO1, DO; TO, RO, LEDO; TO, RO; IO) enthält.

6. Prüfeinrichtung nach einem der vorhergehenden Ansprüche, dadurch gekennzeichnet, daß die Stromversorgung eine Gleichrichterschaltung (Dg1—Dg4) aufweist, die eingangsseitig von der Meßspannung beaufschlagt ist und die ausgangsseitig den Spannungsteiler (R1—R7; R1—R3) sowie die Anzeigeeinheit speist.

7. Prüfeinrichtung nach Anspruch 6, dadurch gekennzeichnet, daß die Stromversorgung einen zwischen die Gleichrichterschaltung (Dg1—Dg4) und die Anzeigeeinheit geschalteten Regelverstärker (TS1, TS2) aufweist, dessen Regeleingang an einen Abgriff des Spannungsteilers (R1—R7) gelegt ist, und daß zwischen der Gleichrichterschaltung und dem Regelverstärker eine Reihenschaltung aus einem keramischen Kaltleiter (PCT) und einem Festwiderstand (RS3) angeordnet ist.

8. Prüfeinrichtung nach Anspruch 6, dadurch gekennzeichnet, daß dem Eingang der Gleichrichterschaltung eine weitere Anzeigeeinheit parallel geschaltet ist, die eine Antiparallelschaltung zweier Leuchtdioden (LED P$^+$, LED P$^-$), einen dazu in Reihe geschalteten weiteren keramischen Kaltleiter (PCT2) sowie einen dem weiteren Kaltleiter parallel geschalteten Schaltungsteil umfaßt, der aus einer Reihenschaltung folgender Elemente besteht: einer ersten Glimmlampe (Gl1), der Parallelschaltung aus einer zweiten Glimmlampe (Gl2)

und einem ersten Widerstand (RA3), einer weiteren Parallelschaltung einer dritten Glimmlampe (Gl3) mit einem zweiten Widerstand (RA2), sowie einem dritten Widerstand (RA1).

9. Prüfeinrichtung nach einem der Ansprüche 1 bis 5, dadurch gekennzeichnet, daß die Stromversorgung eine Batterie (B) umfaßt.

10. Prüfeinrichtung nach einem der vorhergehenden Ansprüche, dadurch gekennzeichnet, daß die Leuchtelemente aus Leuchtdioden bestehen.

11. Prüfeinrichtung nach einem der vorhergehenden Ansprüche, dadurch gekennzeichnet, daß die Widerstände des Spannungssteilers und die Transistoren bzw. die Operationsverstärker in einen Baustein integriert sind.

## Claims

1. Test apparatus for the step-by-step display of a measuring voltage ($U_E$), which comprises two handles provided with contact points and connected by a cable, one accommodating a display unit which contains both a series connection of non-linear luminous elements (O1—On) and a voltage divider which consists of a plurality of series-connected resistors (R1—Rn + 1), supplied with the measuring voltage, characterised in that at each of the taps of the voltage divider formed by the connection points of the resistors (R1—Rn + 1) there is connected the base of one respective transistor (T1—Tn) whose emitter is connected to one terminal of one of the luminous elements (O1—On) and whose collector is connected with the collectors of the remaining transistors to a terminal of one current supply unit (B, TO, RO1, DO) whose other terminal is connected to the other terminal of the luminous element (O1) at the end of the series connection.

2. Test apparatus for the step-by-step display of a measuring voltage ($U_E$), which comprises two handles provided with contact points and connected by a cable, one accommodating a display unit which contains both a series connection of non-linear luminous elements (O1—On) and a voltage divider which consists of a plurality of series-connected resistors (R1—Rn + 1), fed with the measuring voltage, characterised in that at each of the taps of the voltage divider which are formed by the connection points of the resistors (R1—Rn + 1) there is connected a non-inverting input of an operational amplifier (A1—An) the output of which operational amplifier is in each case connected to one terminal of one of the luminous elements (LED1—LEDn), and also to the inverting input of the respective operational amplifier, and that there is provided a current supply unit (B, IO) which is connected by one terminal to a supply input of one operational amplifier and by its other terminal connected to the other terminal of the luminous element (LED1) at the end of the series connection.

3. Test apparatus for the step-by-step display of a measuring voltage ($U_E$), which comprises two handles provided with contact points and connected by a cable, one accommodating a display unit which contains both a number of non-linear luminous elements (O1—On) and a voltage divider which consists of a plurality of series-connected resistors (R1—Rn + 1), fed with the measuring voltage, characterised in that at each of the taps of the voltage divider, formed by the connection points of the resistors (R1—Rn + 1), there is connected the base of a respective transistor (T1—Tn) whose collector is connected to the one terminal of one of the luminous elements (O1—On) that there is provided a series connection of non-linear switching elements (D1—Dn) whose one terminal is in each case connected to the emitter of one of the transistors (T1—Tn), and that there is provided a current supply unit (B, TO, RO1, DO) which has one terminal connected to the other terminal of a luminous element and which has its own other terminal connected to the other terminal of the non-linear switching element (D1) at the end of the series connection.

4. Test apparatus for the step-by-step display of a measuring voltage ($U_E$), which comprises two handles provided with contact points and connected by a cable, one of which accommodates a display unit which contains a number of non-linear luminous elements (LED1—LEDn) and a voltage divider which consists of a plurality of series-connected resistors (R1—Rn + 1) and is supplied with the measuring voltage, characterised in that at each of the taps of the voltage divider formed by the connection points of the resistors (R1—Rn + 1) there is connected the non-inverting input of one operational amplifier (A1—An), that there is provided a series connection consisting of non-linear switching elements (D1—Dn), where the one terminal of these switching elements is connected to the inverting input of a respective one of the operational amplifiers (A1—An), the output of each operational amplifier is fed back to the inverting input by means of one of the luminous elements (LED1—LEDn), and that there is provided a voltage supply unit (B, IO) whose one terminal is connected to a supply input of a respective operational amplifier (A1—An) and whose other terminal is connected to the other terminal of the non-linear switching element (D1) at the end of the series connection.

5. Test apparatus as claimed in one of the preceding Claims, characterised in that the current supply unit comprises a constant current source (TO, RO1, DO; TO, RO, LEDO; TO, RO; IO).

6. Test apparatus as claimed in one of the preceding Claims, characterised in that the current supply unit possesses a rectifier connection (Dg1—Dg4) fed by the measuring voltage at the input end to feed both the voltage divider (R1—R7; R1—R3) and display unit at the output end.

7. Test apparatus as claimed in one of the preceding Claims, characterised in that the current supply unit possesses a regulating amplifier (TS1, TS2) inserted between the rectifier connection (Dg1—Dg4) and the display unit, and whose regulating input is connected to a tap of the voltage divider (R1—R7), and that between the rectifier connection and the regulating amplifier there is arranged a series connection consisting of a ceramic cold conductor (PCT) and a fixed resistor (RS3).

8. Test apparatus as claimed in Claim 6, characterised in that a further display unit is connected in parallel to the input of the rectifier connection, which display unit comprises an anti-parallel connection of two luminous diodes (LED P$^+$, LED P$^-$), a further ceramic cold conductor (PCT2) connected in series to the anti-parallel connection of two luminous diodes, and a switching component connected in parallel to the further cold conductor, which switching component consists of a series connection of the following elements: a first glow lamp (GI1), the parallel connection consisting of a second glow lamp (GI2) and a first resistor (RA3), a further parallel connection of a third glow lamp (GI3) and a second resistor (RA2) and a third resistor (RA1).

9. Test apparatus as claimed in one of Claims 1 to 5, characterised in that the current supply unit comprises a battery (B).

10. Test apparatus as claimed in one of the preceding Claims, characterised in that the luminous elements consist of luminous diodes.

11. Test apparatus as claimed in one of the preceding Claims, characterised in that the resistors of the voltage divider and the transistors or operational amplifiers, as the case may be, are integrated into a module.

**Revendications**

1. Dispositif de contrôle pour afficher par paliers une tension à mesurer ($U_E$), qui comporte deux poignées munies de pointes de contact, qui sont reliées par un câble, et dont une contient une unité d'affichage qui comprend un circuit série formé par des éléments photoluminescents non linéaires (O1—On) ainsi qu'un diviseur de tension formé par plusieurs résistances (R1—Rn + 1) branchées en séries et recevant la tension à mesurer, caractérisé par le fait qu'à chacune des prises du diviseur de tension, formées par les points de jonction des résistances (R1—Rn + 1), est respectivement reliée la base d'un transistor respectif (T1—Tn), dont l'émetteur est respectivement relié à une des bornes d'un élément photoluminescent respectif (O1—On) et dont le collecteur est respectivement relié aux collecteurs des transistors restants ainsi qu'à une borne d'une alimentation en courant (B, TO, RO1, DO) dont l'autre borne est reliée à l'autre borne de l'élément photoluminescent (O1) à l'extrémité du circuit série.

2. Dispositif de contrôle pour afficher par paliers une tension à mesurer ($U_E$), qui comporte deux poignées munies de pointes de contact, qui sont reliées par un câble, et dont une contient une unité d'affichage qui comprend un circuit série formé par des éléments photoluminescents non linéaires (O1—On), ainsi qu'un diviseur de tension formé par plusieurs résistances (R1—Rn + 1) branchées en séries et recevant la tension à mesurer, caractérisé par le fait qu'à chacune des prises du diviseur de tension, formées par les points de jonction des résistances (R1—Rn + 1), est respectivement reliée l'entrée non inverseuse d'un amplificateur opérationnel (A1—An) dont la sortie est respectivement reliée à une des bornes d'une des éléments photoluminescents (LED1—LEDn) ainsi qu'à l'entrée inverseuse de l'amplificateur opérationnel concerné, et qu'il est prévu une alimentation en courant (B, IO) dont une des bornes est respectivement reliée à une entrée d'alimentation de chaque amplificateur opérationnel et dont l'autre entrée est reliée à l'autre borne de l'élément photoluminescent (LED1) à l'extrémité du circuit série.

3. Dispositif de contrôle pour afficher par paliers une tension à mesurer ($U_E$), qui comporte deux poignées munies de pointes de contact, qui sont reliées par un câble, et dont une contient une unité d'affichage qui comprend un circuit série formé par des éléments photoluminescents non linéaires (O1—On), ainsi qu'un diviseur de tension formé par plusieurs résistances (R1—Rn + 1) branchées en séries et recevant la tension à mesurer, caractérisé par le fait qu'à chacune des prises du diviseur de tension, formées par les points de jonction des résistances (R1—Rn + 1), est respectivement reliée la base d'un transistor respectif (T1—Tn) dont le collecteur est respectivement relié à une des bornes d'un élément photoluminescent respectif (O1—On), qu'il est prévu un circuit série d'éléments de commutation non linéaires (D1—Dn) dont une borne est respectivement reliée à l'émetteur d'un des transistors (T1—Tn), et qu'il est prévu une alimentation en courant (B, TO, RO1, DO) dont une borne est respectivement reliée à l'autre borne de chaque élément photoluminescent et dont l'autre borne est reliée à l'autre borne de l'élément de commutation non linéaire (D1) à l'extrémité du circuit série.

4. Dispositif de contrôle pour afficher par paliers une tension à mesurer ($U_E$), qui comporte deux poignées munies de pointes de contact, qui sont reliées par un câble, et dont une contient une unité d'affichage qui comprend un certain nombre d'éléments photoluminescents non linéaires (LED1—LEDn) ainsi qu'un diviseur de tension formé par plusieurs résistances (R1—Rn + 1) branchées en séries et recevant la tension à mesurer, caractérisé par le fait qu'à chacune des prises du diviseur de tension, formées par les points de jonction des résistances (R1—Rn + 1), est reliée l'entrée non inverseuse d'un amplificateur opérationnel respectif (A1—An), qu'il est prévu un circuit série d'éléments de commutation non linéaires (D1—Dn), une des bornes de ces éléments de commutation étant respectivement reliée à l'entrée inverseuse de chacun des amplificateurs opérationnels (A1—An), que la sortie de chaque amplificateur opérationnel est ramenée à l'entrée inverseuse, respectivement par l'intermédiaire d'un des éléments photoluminescents (LED1—LEDn), et qu'il est prévu une alimentation en tension (B, IO) dont une borne est respectivement reliée à une entrée d'alimentation de chaque amplificateur opérationnel (A1—An) et dont l'autre borne est reliée à l'autre borne de l'élément de commutation non linéaire (D1) à l'extrémité du circuit série.

5. Dispositif de contrôle suivant l'une des revendications précédentes, caractérisé par le fait que l'alimentation en courant contient une source de courant constant (TO, RO1, DO; TO, RO, LEDO; TO, RO; IO).

6. Dispositif de contrôle suivant l'une des revendications précédentes, caractérisé par le fait que l'alimentation en courant comporte un circuit redresseur (Dg1—Dg4) qui, côté entrée, reçoit la tension à mesurer et, côté sortie, alimente le diviseur de tension (R1—R7; R1—R3) ainsi que l'unité d'affichage.

7. Dispositif de contrôle suivant la revendication 6, caractérisé par le fait que l'alimentation en courant comporte un amplificateur de réglage (TS1, TS2), monté entre le circuit redresseur (Dg1—Dg4) et l'unité d'affichage, dont l'entrée de réglage est reliée à une prise du diviseur de tension (R1—R7), et qu'entre le dispositif redresseur et l'amplificateur de réglage est monté un circuit série constitué par une résistance céramique à coefficient positif de température (PTC) et une résistance fixe (RS3).

8. Dispositif de contrôle suivant la revendication 6, caractérisé par le fait qu'en parallèle sur l'entrée de circuit redresseur est branchée une autre unité d'affichage qui comprend un montage en antiparallèle de deux diodes photoluminescentes (LED $P^+$, LED $P^-$), une autre résistance céramique à coefficient de température positif (PTC2), montée en série avec ce circuit, ainsi qu'une partie de circuit montée en parallèle sur l'autre résistance à coefficient de température positif, partie de circuit qui est constituée par un circuit série des éléments suivants: une première lampe au néon (GI1), le montage en parallèle d'une seconde lampe au néon (GI2) et d'une première résistance (RA3), un autre montage en parallèle d'une troisième lampe au néon (GI3) et d'une seconde résistance (RA2), ainsi qu'une troisième résistance (RA1).

9. Dispositif de contrôle suivant l'une des revendications 1 à 5, caractérisé par le fait que l'alimentation en courant comprend une pile (B).

10. Dispositif de contrôle suivant l'une des revendications précédentes, caractérisé par le fait que les éléments photoluminescents sont constitués par des diodes photoluminescentes.

11. Dispositif de contrôle suivant l'une des revendications précédentes, caractérisé par le fait que les résistances du diviseur de tension et les transistors ou les amplificateurs opérationnels sont intégrés dans un composant.

FIG 1

**0011711**

# FIG 2

# FIG 3

**0011711**

# FIG 4

# FIG 5

FIG 6